(19) Europäisches Patentamt
European Patent Office
Office européen des brevets

(11) **EP 4 517 354 A1**

(12) **EUROPEAN PATENT APPLICATION**
published in accordance with Art. 153(4) EPC

(43) Date of publication:
**05.03.2025   Bulletin 2025/10**

(21) Application number: **23795104.1**

(22) Date of filing: **18.04.2023**

(51) International Patent Classification (IPC):
**G01R 31/388** (2019.01)   **G01R 31/389** (2019.01)
**G01R 31/396** (2019.01)   **G01R 31/367** (2019.01)

(52) Cooperative Patent Classification (CPC):
**G01R 31/367; G01R 31/388; G01R 31/389;**
**G01R 31/396;** Y02E 60/10

(86) International application number:
**PCT/CN2023/088942**

(87) International publication number:
**WO 2023/207671 (02.11.2023 Gazette 2023/44)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **27.04.2022   CN 202210457988**

(71) Applicant: **Huawei Technologies Co., Ltd.**
**Shenzhen, Guangdong 518129 (CN)**

(72) Inventors:
• **LI, Yuan**
  **Shenzhen, Guangdong 518129 (CN)**
• **CUI, Rui**
  **Shenzhen, Guangdong 518129 (CN)**
• **RUAN, Jiahao**
  **Shenzhen, Guangdong 518129 (CN)**
• **LIU, Yutao**
  **Shenzhen, Guangdong 518129 (CN)**
• **WANG, Han**
  **Shenzhen, Guangdong 518129 (CN)**

(74) Representative: **Maiwald GmbH**
**Engineering**
**Elisenhof**
**Elisenstrasse 3**
**80335 München (DE)**

(54)   **BATTERY LEVEL STATE DETERMINATION METHOD**

(57)    This application relates to the field of terminal devices, and discloses a method for determining a battery level status, to implement mapping based on battery usage data, and obtain a mapped target battery level. In this way, battery stability can be enhanced, and a battery can be further protected. In the method, a battery protection voltage parameter is determined based on battery usage data, where the battery protection voltage parameter is used to change an original voltage parameter corresponding to a battery level; a second mapping relationship between an actual battery level and a target battery level is determined based on the battery protection voltage parameter; and the target battery level is determined based on the second mapping relationship and the actual battery level of the battery. Alternatively, a correspondence between an actual battery voltage and a target battery level is determined based on the battery protection voltage parameter; and the target battery level is determined based on the correspondence and the actual battery voltage of the battery.

FIG. 4

EP 4 517 354 A1

**Description**

**CROSS-REFERENCE TO RELATED APPLICATIONS**

This application claims priority to Chinese Patent Application No. 202210457988.9, filed with the China National Intellectual Property Administration on April 27, 2022 and entitled "METHOD FOR DETERMINING BATTERY LEVEL STATUS", which is incorporated herein by reference in its entirety.

**TECHNICAL FIELD**

Embodiments of this application relate to the field of terminal devices, and in particular, to a method for determining a battery level status.

**BACKGROUND**

As application scenarios of a terminal device in daily life of a user become increasingly extensive and important, a requirement for increasing a battery storage capacity of the terminal device becomes increasingly urgent. In addition to increasing battery space in a body structure, different battery preparation means may be used, to increase the battery storage capacity.

Currently, a battery preparation means used by most types of terminal devices is to use graphite as a battery negative electrode material, to achieve stable performance. Another battery preparation means is to use silicon as a battery negative electrode material. Compared with a graphite negative electrode battery, a silicon negative electrode battery may have a larger battery storage capacity under a same condition. However, currently, a manner for controlling a silicon negative electrode battery is absent.

**SUMMARY**

Embodiments of this application provide a method for determining a battery level status, to implement mapping based on battery usage data, and obtain a mapped target battery level, so that not only a remaining battery level but also a battery usage status can be reflected based on the target battery level. Therefore, battery stability can be enhanced, and a battery can be further protected.

According to a first aspect, an embodiment of this application provides a method for determining a battery level status. The method includes: determining a battery protection voltage parameter based on battery usage data, where the battery usage data is used to reflect a usage status of a battery within a preset time period, and the battery protection voltage parameter is used to change an original voltage parameter corresponding to a battery level; determining a second mapping relationship between an actual battery level and a target battery level based on the battery protection voltage parameter; and determining the target battery level based on the second mapping relationship and the actual battery level of the battery.

In the method, mapping from a battery voltage to the battery level is implemented by calculating a mapping manner between the target battery level and the actual battery level. Therefore, the target battery level obtained through mapping can not only reflect the actual battery level of the battery, but also can reflect a voltage status of the battery, so that when a battery voltage is low, a low target battery level can be obtained through mapping. In this way, a user can be reminded in a timely manner to charge a battery, and the battery can be prevented from being in a low-voltage state for a longer time. Therefore, a case in which the battery works in a dangerous voltage range for a long time can be better avoided based on dynamic mapping based on the battery voltage and the battery level. For example, a silicon negative electrode battery has unstable performance in a low voltage range, and therefore, a battery power-off voltage may be increased when the silicon negative electrode battery is used. Alternatively, for example, if a battery made of another material has poor performance in another voltage range (for example, a high voltage range) in the future, the battery may be protected by reducing a full charge voltage of the battery, to prolong a lifespan of the battery.

In a possible design, the determining a battery protection voltage parameter based on battery usage data includes: determining, based on a preconfigured first mapping relationship, the battery protection voltage parameter corresponding to the battery usage data. In this design, a mapping relationship between the battery usage data and the battery protection voltage parameter may be preconfigured through an experiment, deep learning, or the like. Further, the battery protection voltage parameter may be determined by using the preconfigured first mapping relationship, to adjust the battery voltage, so that the battery works in a safe voltage range to a greater extent.

In a possible design, the preconfigured first mapping relationship may be used to reflect correspondences between different battery usage data values and different battery protection voltage parameter values; or the preconfigured first mapping relationship may be used to reflect correspondences between different battery usage data ranges and different battery protection voltage parameter values or ranges. In this design, the preconfigured first mapping relationship may be a correspondence between a value and a value, a correspondence between a value and a range, or a correspondence between a range and a range. During implementation, different mapping manners may be used to adapt to various requirements, for example, a precision requirement, in different application scenarios.

In a possible design, the determining a second mapping relationship between an actual battery level and a target battery level based on the battery protection voltage parameter includes: determining, based on a first modeling parameter, the second mapping relationship corresponding to the battery protection voltage parameter, where the first modeling parameter indicates a correspondence between a battery voltage and a battery level. In this design, modeling may be performed on mapping between the battery voltage and the battery level in advance, and then a correspondence between an original battery voltage and an original battery level and a correspondence between a target battery voltage and the target battery level may be determined based on the first modeling parameter. Therefore, the mapping relationship between the actual battery level and the target battery level can be further determined based on the two correspondences, so that a mapped target battery level can be determined.

In a possible design, the battery usage data includes one or more of the following information: a full charge capacity, a first battery level when charging starts, a second battery level when charging stops, battery usage duration, and a quantity of battery cycles. In this design, data related to battery charging may be obtained based on the battery usage data, or data related to battery usage may be obtained based on the battery usage data, or the like, so that a battery usage habit or the like can be obtained through analysis. For example, a charging habit of the user is determined. If the user is accustomed to starting to charge the battery only when the battery level of the battery is low, because a problem of unstable performance may exist when the battery is at a low voltage, a power-off voltage may be increased to implement a mapped target battery level. This prevents the user from using the low-voltage battery for a long time.

In a possible design, before the determining a battery protection voltage parameter based on battery usage data, the method further includes: receiving and responding to a preset collection instruction, and collecting and performing statistics collection on the battery usage data, where the preset collection instruction includes but is not limited to: detecting power-on of a terminal device; or detecting charging of the terminal device; or receiving a user operation instruction for enabling battery optimization by the user. In this design, a plurality of implementations of obtaining the battery usage data may be set based on an actual scenario requirement.

In a possible design, the battery protection voltage parameter includes but is not limited to at least one of the following parameters: a target power-off voltage obtained by changing an original power-off voltage that is included in the original voltage parameter; and a target full charge voltage obtained by changing an original full charge voltage that is included in the original voltage parameter. In this design, one or a combination of a power-off voltage and a full charge voltage is adjusted, so that a working voltage range of the battery can be adjusted, thereby preventing the battery from being in an unstable working voltage range for a long time.

In a possible design, the battery protection voltage parameter is represented in, but not limited to, one of the following forms: an absolute value of a change value; a relative value of a change ratio; and a target value obtained after a change.

In a possible design, obtaining the actual battery level of the battery includes: continuously collecting a battery parameter used to determine the actual battery level, or periodically collecting the battery parameter, or receiving a request instruction, and collecting the battery parameter in response to the request instruction; and determining the actual battery level based on the battery parameter.

According to a second aspect, an embodiment of this application further provides a method for determining a battery level status. In the method, a battery protection voltage parameter is determined based on battery usage data, where the battery usage data is used to reflect a usage status of a battery within a preset time period, and the battery protection voltage parameter is used to change one or more original battery voltages corresponding to a battery level; a correspondence between an actual battery voltage and a target battery level is determined based on the battery protection voltage parameter; and the target battery level is determined based on the correspondence and the actual battery voltage of the battery.

In the method, a mapping relationship between a battery voltage and the battery level is changed, so that the battery level can be obtained through mapping based on the battery voltage. Therefore, the target battery level obtained through mapping can not only reflect the actual battery level of the battery, but also can reflect a voltage status of the battery, so that when a battery voltage is low, a low target battery level can be obtained through mapping. In this way, a user can be reminded in a timely manner to charge a battery, and the battery can be prevented from being in a low-voltage state for a longer time. Therefore, a case in which the battery works in a dangerous voltage range for a long time can be better avoided based on dynamic mapping based on the battery voltage and the battery level. For example, a silicon negative electrode battery has unstable performance in a low voltage range, and therefore, a battery power-off voltage may be increased when the silicon negative electrode battery is used. Alternatively, for example, if a battery made of another material has poor performance in another voltage range (for example, a high voltage range) in the future, the battery may be protected by reducing a full charge voltage of the battery, to prolong a lifespan of the battery.

In a possible design, the determining a battery protection voltage parameter based on battery usage data includes: determining, based on a preconfigured first mapping relationship, the battery protection voltage parameter corresponding to the battery usage data.

In a possible design, the preconfigured first mapping relationship is used to reflect correspondences between different battery usage data values and different battery protection voltage parameter values; or the preconfigured first mapping relationship is used to reflect correspondences between different battery usage data ranges and different battery protection voltage parameter values or ranges.

In a possible design, the determining a correspondence between an actual battery voltage and a target battery level based on the battery protection voltage parameter includes: switching a first modeling parameter to a second modeling parameter based on a preconfigured third mapping relationship, where the first modeling parameter indicates an original correspondence between a battery voltage and a battery level, and the second modeling parameter indicates a target correspondence between the battery voltage and the battery level. In this design, a mapping relationship between the battery protection voltage parameter and a modeling parameter may be preconfigured through an experiment, deep learning, or the like. For example, different modeling parameters corresponding to different battery protection voltage parameters may be prestored. In this way, when different battery protection voltage parameters are used, different modeling parameters can be switched for use. Further, a proper correspondence between a battery voltage and a battery level can be obtained, to adjust the battery voltage, so that the battery works in a safe voltage range to a greater extent.

In a possible design, the battery usage data includes but is not limited to one or more of the following information: a full charge capacity, a first battery level when charging starts, a second battery level when charging stops, battery usage duration, and a quantity of battery cycles.

In a possible design, before the determining a battery protection voltage parameter based on battery usage data, the method further includes: receiving and responding to a preset collection instruction, and collecting and performing statistics collection on the battery usage data, where the preset collection instruction includes but is not limited to: detecting power-on of a terminal device; or detecting charging of the terminal device; or receiving a user operation instruction for enabling battery optimization by the user.

In a possible design, the battery protection voltage parameter includes at least one of the following parameters: a target power-off voltage obtained by changing an original power-off voltage that is included in the original voltage parameter; and a target full charge voltage obtained by changing an original full charge voltage that is included in the original voltage parameter.

In a possible design, the battery protection voltage parameter is represented in, but not limited to, one of the following forms: an absolute value of a change value; a relative value of a change ratio; and a target value obtained after a change.

In a possible design, obtaining the actual battery level of the battery includes: continuously collecting a battery parameter used to determine the actual battery level, or periodically collecting the battery parameter, or receiving a request instruction, and collecting the battery parameter in response to the request instruction; and determining the actual battery level based on the battery parameter.

According to a third aspect, this application provides a terminal device. The terminal device includes a plurality of function modules. The plurality of function modules interact with each other, to implement the method performed by the terminal device in any one of the foregoing aspects and the implementations of the foregoing aspects. The plurality of function modules may be implemented based on software, hardware, or a combination of software and hardware, and the plurality of function modules may be randomly combined or divided based on specific implementation. For example, in this embodiment of this application, the plurality of function modules may include a collection module, a processing module, a transceiver module, and the like. The collection module may be configured to collect battery usage data, the processing module may be configured to determine a battery level status in this application, and the transceiver module may be configured to receive an actual battery level obtained by a hardware unit, and the like.

According to a fourth aspect, this application provides a terminal device, including at least one processor and at least one memory. The at least one memory stores computer program instructions. When the terminal device runs, the at least one processor performs the method performed by the terminal device in any one of the foregoing aspects and the implementations of the foregoing aspects.

According to a fifth aspect, this application further provides a computer-readable storage medium. The computer-readable storage medium stores a computer program. When the computer program is executed by a computer, the computer is enabled to perform the method performed by the terminal device in any one of the foregoing aspects and the possible designs of the foregoing aspects.

According to a sixth aspect, this application provides a computer program product. The computer program product includes a computer program (which may also be referred to as code or instructions). When the computer program is run, a computer is enabled to perform the method performed by the terminal device in any one of the foregoing aspects and the possible designs of the foregoing aspects.

According to a seventh aspect, an embodiment of this application further provides a graphical user interface on a terminal device. The terminal device has a display, one or more memories, and one or more processors. The one or more processors are configured to execute one or more computer programs stored in the one or more memories, and the graphical user interface includes a graphical user interface displayed when the terminal device performs any one of the foregoing aspects and the possible designs of the foregoing aspects. For example, after determining a mapped target battery level, the terminal device may display the target battery level on the graphical user interface, for example, at a position in an upper right corner.

According to an eighth aspect, this application further provides a chip. The chip is configured to read a computer program stored in a memory, to perform the method performed by the terminal device in any one of the foregoing aspects and the possible designs of the foregoing aspects.

According to a ninth aspect, this application further provides a chip system. The chip system includes a processor, configured to support a computer apparatus in implementing the method performed by the terminal device in any one of the foregoing aspects and the possible designs of the foregoing aspects. In a possible design, the chip system further includes a memory, and the memory is configured to store a program and data that are necessary for the computer apparatus. The chip system may include a chip, or may include a chip and another discrete component.

For beneficial effects of any one of the second aspect to the ninth aspect and the possible designs of the second aspect to the ninth aspect, refer to beneficial effects of the possible designs in the first aspect. Details are not described herein again.

**BRIEF DESCRIPTION OF DRAWINGS**

FIG. 1 is a possible diagram of a hardware structure of a terminal device according to an embodiment of this application;

FIG. 2 is a block diagram of a software architecture of a terminal device according to an embodiment of this application;

FIG. 3 is a diagram of a hardware structure to which a method for determining a battery level status is applicable according to an embodiment of this application;

FIG. 4 is a schematic flowchart of a method for determining a battery level status according to an embodiment of this application;

FIG. 5 is a diagram of a display interface of a terminal device according to an embodiment of this application;

FIG. 6 is another schematic flowchart of a method for determining a battery level status according to an embodiment of this application; and

FIG. 7 is a diagram of a structure of an apparatus for determining a battery level status according to an embodiment of this application.

**DESCRIPTION OF EMBODIMENTS**

The following describes in detail embodiments of this application with reference to accompanying drawings.

The technical solutions provided in embodiments of this application may be applied to the field of terminal devices. A terminal device usually needs a battery to support normal use of the device. Therefore, how to increase a battery storage capacity of the terminal device is of great research significance. It may be considered that larger placement space is configured for the battery in the terminal device, to increase the battery storage capacity by increasing a volume of the battery. However, due to a limitation of a hardware structure of the terminal device, the increase of the battery storage capacity is limited. In addition, a battery preparation means may be further considered. A battery preparation manner is improved, so that a battery of a same volume can have a larger battery storage capacity.

Currently, the battery used in the terminal device is usually a lithium-ion battery. The lithium-ion battery mainly includes parts such as a positive electrode material, a negative electrode material, an electrolyte, and a housing. Parts that mainly affect the storage capacity and energy of the battery are the positive and negative electrode materials of the battery. Graphite has characteristics such as being relatively stable and being insensitive to a low voltage. Therefore, a negative electrode material generally used by a mainstream terminal device in a current market is graphite.

In some examples, if silicon is used as the negative electrode material of the battery, compared with a graphite negative electrode battery, a silicon negative electrode battery may have a larger battery storage capacity under a same condition. For example, a graphite negative electrode battery whose battery storage capacity is 2300 mAh (mAh) is used as an example. If a negative electrode material of the battery is replaced with silicon, the battery storage capacity may be increased by about 140 mAh. However, the silicon negative electrode battery has features such as a low discharge platform, an increase in capacity attenuation at a low voltage, and easy expansion during a charging/discharging cycle. As a result, the silicon negative electrode battery cannot be well applied. In some current research, it is mainly considered that a new preparation method or a new mixing ratio of preparation materials is used to improve performance of the silicon negative electrode battery or reduce a probability of battery expansion. However, a preferable preparation method to enable the silicon negative electrode battery to be widely applied is absent.

In view of this, embodiments of this application provide a method for determining a battery level status, to control a battery like a silicon negative electrode battery. During implementation of this application, dynamic mapping between battery voltage data and a battery level status is implemented based on some collected battery-related usage data. Further, a new display manner of reflecting the battery level status is provided based on the battery level status (for example, the battery level status may be displayed as a battery level). According to the method, a mapped battery level status may reflect a status of a remaining battery capacity, and may further reflect a battery voltage status. For example, a low battery voltage may be mapped to a low battery level, to trigger a power saving mode of a terminal device or remind a user of an operation like performing timely charging. In addition, when a battery voltage is lower than a voltage threshold, the battery voltage may be mapped to a battery state of having no battery level, to trigger an operation like power-off of the terminal device. In this way, rapid attenuation of a battery level as a type of battery like a silicon-like negative electrode battery is in a low-voltage state for a long time can be prevented, and battery expansion and the like can be avoided, to improve battery stability, prolong a service lifespan of the battery, and the like. It may be understood that the method provided in embodiments of this application is applicable to a silicon negative electrode battery, or may be further applicable to a battery, in another preparation means, that may exist in the future and that has characteristics similar to those of the silicon negative electrode battery. This is not limited in this application.

It may be understood that the terminal device in embodiments of this application may be a device like a mobile phone, a tablet computer, a notebook computer, an ultra-mobile personal computer (ultra-mobile personal computer, UMPC), a netbook, a smart home device (for example, a smart television, a smart screen, or a smart speaker), a wearable device (for example, a watch, a helmet, or a headset), an augmented reality (augmented reality, AR)/virtual reality (virtual reality, VR) device, or a personal digital assistant (personal digital assistant, PDA). It may be understood that a specific type of the terminal device is not limited in embodiments of this application.

In an example embodiment, a terminal device to which embodiments of this application may be applied includes but is not limited to a portable terminal device carrying HarmonyOS®, iOS®, Android®, Microsoft®, or another operating system. Alternatively, the portable terminal device may be another portable terminal device, for example, a laptop (Laptop) computer with a touch-sensitive surface (for example, a touch panel).

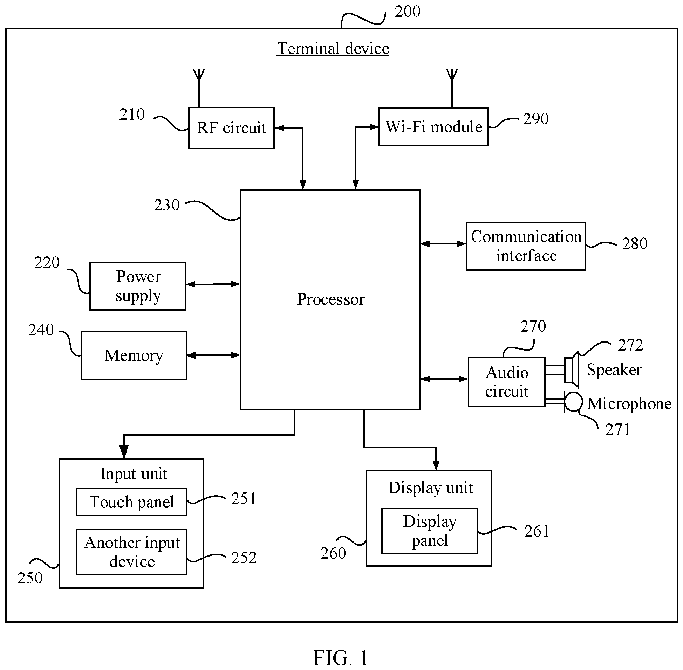

FIG. 1 shows a possible diagram of a hardware structure of a terminal device. A terminal device 200 includes components such as a radio frequency (radio frequency, RF) circuit 210, a power supply 220, a processor 230, a memory 240, an input unit 250, a display unit 260, an audio circuit 270, a communication interface 280, and a wireless-fidelity (wireless-fidelity, Wi-Fi) module 290. A person skilled in the art may understand that the hardware structure of the terminal device 200 shown in FIG. 1 does not constitute a limitation on the terminal device 200. The terminal device 200 provided in this embodiment of this application may include more or fewer components than those shown in the figure, two or more components may be combined, or a different component configuration may be used. The various components shown in FIG. 1 may be implemented in hardware including one or more signal processing circuits and/or applicationspecific integrated circuits, software, or a combination of hardware and software.

The following describes each component of the terminal device 200 in detail with reference to FIG. 1.

The RF circuit 210 may be configured to receive and send data in a communication or call process. Specifically, after receiving downlink data from a base station, the RF circuit 210 sends the downlink data to the processor 230 for processing. In addition, the RF circuit 210 sends to-be-sent uplink data to the base station. Generally, the RF circuit 210 includes but is not limited to an antenna, at least one amplifier, a transceiver, a coupler, a low noise amplifier (low noise amplifier, LNA), and a duplexer.

In addition, the RF circuit 210 may further communicate with another device through a wireless communication network. The wireless communication may use any communication standard or protocol, including but not limited to a global system for mobile communications (global system for mobile communications, GSM), a general packet radio service (general packet radio service, GPRS), code division multiple access (code division multiple access, CDMA), wideband code division multiple access (wideband code division multiple access, WCDMA), long term evolution (long term evolution, LTE), an email, a short message service (short message service, SMS), and the like.

A Wi-Fi technology belongs to a short-range wireless transmission technology. The terminal device 200 may be connected to an access point (access point, AP) by using the Wi-Fi module 290, to access a data network. The Wi-Fi module 290 may be configured to receive and send data in a communication process.

The terminal device 200 may be physically connected to another device through the communication interface 280. Optionally, the communication interface 280 is connected to a communication interface of the another device through a cable, to implement data transmission between the terminal device 200 and the another device.

The terminal device 200 can further implement a communication service, and interact with a service side device or another terminal device. Therefore, the terminal device 200 needs to have a data transmission function, that is, the terminal device 200 needs to internally include a communication module. Although FIG. 1 shows communication modules such as the RF circuit 210, the Wi-Fi module 290, and the communication interface 280, it may be understood that the terminal device 200 includes at least one of the foregoing components or another communication module (for example, a Bluetooth module) configured to implement communication, to perform data transmission.

For example, when the terminal device 200 is a mobile phone, the terminal device 200 may include the RF circuit 210, and may further include the Wi-Fi module 290, or may include a Bluetooth module (not shown in FIG. 1). When the terminal device 200 is a computer, the terminal device 200 may include the communication interface 280, and may further include the Wi-Fi module 290, or may include a Bluetooth module (not shown in FIG. 1). When the terminal device 200 is a tablet computer, the terminal device 200 may include the Wi-Fi module, or may include a Bluetooth module (not shown in FIG. 1).

The memory 240 may be configured to store a software program and a module. The processor 230 runs the software program and the module that are stored in the memory 240, to execute various function applications of the terminal device 200 and process data. Optionally, the memory 240 may mainly include a program storage area and a data storage area. The program storage area may store an operating system (mainly including software programs or modules respectively corresponding to a kernel layer, a system layer, an application framework layer, an application layer, and the like).

In addition, the memory 240 may include a high-speed random access memory, and may further include a non-volatile memory, for example, at least one magnetic disk storage device, a flash storage device, or another volatile solid-state storage device. In embodiments of this application, information such as a related computer program used to implement the method provided in embodiments of this application or a prestored mapping relationship (for example, a preconfigured first mapping relationship, a prestored second mapping relationship, or a preconfigured third mapping relationship) may be stored in the memory 240.

The input unit 250 may be configured to: receive editing operations on a plurality of data objects of different types such as digit or character information input by a user, and generate key signal input related to user setting and function control of the terminal device 200. Optionally, the input unit 250 may include a touch panel 251 and another input device 252.

The touch panel 251, also referred to as a touchscreen, may collect a touch operation (for example, an operation performed by the user on the touch panel 251 or near the touch panel 251 by using any proper object or accessory like a finger or a stylus) performed by the user on or near the touch panel, and drive a corresponding connection apparatus based on a preset program.

Optionally, the another input device 252 may include but is not limited to one or more of a physical keyboard, a function button (for example, a volume control button or a power on/off button), a trackball, a mouse, a joystick, and the like.

The display unit 260 may be configured to display information input by the user, information provided for the user, and various menus of the terminal device 200. The display unit 260 is a display manner of the terminal device 200, and is configured to present an interface to implement human-computer interaction. The display unit 260 may include a display panel 261. Optionally, the display panel 261 may be configured in a form like a liquid crystal display (liquid crystal display, LCD) or an organic light-emitting diode (organic light-emitting diode, OLED). In this embodiment of this application, the display unit 260 may be configured to display a mapped battery level status obtained by using the method provided in this application, for example, display a battery level, so that the user obtains a battery usage status of the terminal device in a timely manner. In this way, the battery level status is displayed, so that the user can be reminded in a timely manner of charging the battery, powering off the terminal device, or the like.

The processor 230 is a control center of the terminal device 200, is connected to the components through various interfaces and lines, and performs various functions of the terminal device 200 and processes data by running or executing the software program and/or the module stored in the memory 240 and invoking data stored in the memory 240, to implement a plurality of services based on the terminal device 200. In this embodiment of this application, the processor 230 may communicate with a voltameter hardware circuit, to implement the method provided in embodiments of this application. For example, the processor 230 may receive a related parameter that is of the power supply 220 (for example, a battery) and that is collected by the voltameter hardware circuit.

The terminal device 200 further includes the power supply 220 (for example, a battery) configured to supply power to the components. Optionally, the power supply 220 may be logically connected to the processor 230 by using a power management system, to implement functions such as charge management, discharge management, and power consumption management by using the power management system.

As shown in FIG. 1, the terminal device 200 further includes the audio circuit 270, a microphone 271, and a speaker 272, and may provide an audio interface between the user and the terminal device 200. The audio circuit 270 may be configured to: convert audio data into a signal that can be identified by the speaker 272, and transmit the signal to the speaker 272. The speaker 272 converts the signal into a sound signal for output. The microphone 271 is configured to: collect an external sound signal (for example, a sound of a person speaking, or another sound), convert the collected external sound signal into a signal that can be identified by the audio circuit 270, and send the signal to the audio circuit 270. The audio circuit 270 may be further configured to: convert the signal sent by the microphone 271 into audio data, and then output the audio data to the RF circuit 210 for sending to, for example, another terminal device, or output the audio data to the memory 240 for subsequent processing.

Although not shown, the terminal device 200 may further include at least one sensor, a camera, and the like. Details are not described herein again. The at least one sensor may include but is not limited to a pressure sensor, a barometric pressure sensor, an acceleration sensor, a distance sensor, a fingerprint sensor, a touch sensor, a temperature sensor, or the like.

An operating system (operating system, OS) in embodiments of this application is most basic system software running on the terminal device 200. A mobile phone is used as an example. An operating system may be a HarmonyOS (HarmonyOS), an Android (Android) system, or an iOS system. A software system of the terminal device 200 may use a layered architecture, an eventdriven architecture, a microkernel architecture, a microservice architecture, or a cloud architecture. In embodiments of this application, an operating system using a layered architecture is used as an example, to describe a software architecture of the terminal device 200.

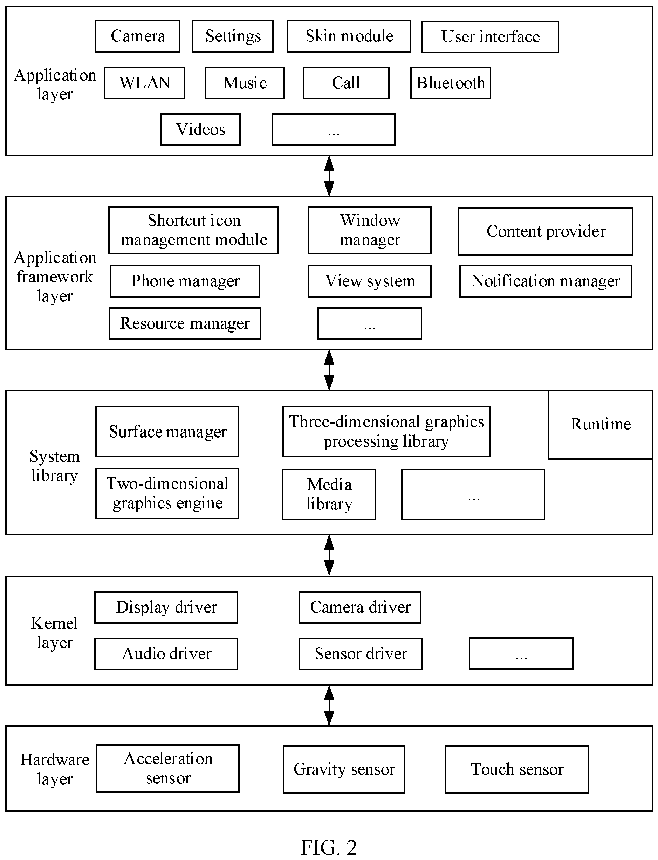

FIG. 2 is a block diagram of a software architecture of a terminal device according to an embodiment of this application. As shown in FIG. 2, the software architecture of the terminal device may be a layered architecture. For example, software may be divided into several layers, and each layer has a clear role and responsibility. The layers communicate with each other through a software interface. In some embodiments, an operating system is divided into five layers: an application layer, an application framework (framework, FWK) layer, a runtime and system library, a kernel layer, and a hardware layer from top to bottom.

The application layer may include a series of application packages. As shown in FIG. 2, the application layer may include Camera, Settings, Skin module, User interface (user interface, UI), a third-party application, and the like. The third-party application may include WLAN, Music, Call, Bluetooth, Videos, and the like.

In a possible implementation, an application may be developed by using a Java language, and is completed by invoking an application programming interface (application programming interface, API) provided by an application framework layer. A developer may interact with a bottom layer (for example, a hardware layer or a kernel layer) of an operating system by using the application framework layer, to develop an application of the developer. The application framework layer mainly includes a series of services and management systems of the operating system.

The application framework layer provides an application programming interface and a programming framework for an application at the application layer. The application framework layer includes some predefined functions. As shown in FIG. 2, the application framework layer may include a shortcut icon management module, a window manager, a content provider, a phone manager, a view system, a notification manager, a resource manager, and the like.

The shortcut icon management module is configured to manage a shortcut icon displayed on the terminal device, for example, create the shortcut icon, remove the shortcut icon, and monitor whether the shortcut icon meets a display condition.

The window manager is configured to manage a window program. The window manager may obtain a size of the display, determine whether there is a status bar, perform screen locking, take a screenshot, and the like. The content provider is configured to: store and obtain data, and enable the data to be accessed by an application. The data may include a video, an image, an audio, calls that are made and answered, a browsing history and a browsing bookmark, an address book, and the like.

The phone manager is configured to provide a communication function of the terminal device, for example, management of a call status (including answering, declining, or the like).

The view system includes a visual control, for example, a control for displaying text, a control for displaying a picture, or a control for displaying a battery level. The view system may be configured to construct an application. A display interface may include one or more views. For example, a display interface including a message notification icon may include a view for displaying a text and a view for displaying a picture.

The notification manager enables an application to display notification information in a status bar, and may be configured to convey a notification message. The notification manager may automatically disappear after a short pause without user interaction. For example, the notification manager is configured to: notify download completion, give a message notification, and the like. The notification manager may alternatively be a notification that appears in a top status bar of the system in a form of a graph or a scroll bar text, for example, a notification of an application that is run on a background, or may be a notification that appears on the screen in a form of a dialog window. For example, text information is displayed in the status bar, a prompt tone is given, the terminal device vibrates, or an indicator light blinks.

The resource manager provides various resources such as a localized character string, an icon, a picture, a layout file, and a video file for an application.

The runtime includes a kernel library and a virtual machine. The runtime is responsible for scheduling and management of an operating system.

The kernel library includes two parts: a functional function that needs to be invoked in Java language and a kernel library of the operating system. The application layer and the application framework layer run on the virtual machine. The virtual machine executes java files at the application layer and the application framework layer as binary files. The virtual machine is configured to implement functions such as object lifecycle management, stack management, thread management, security and exception management, and garbage collection.

The system library may include a plurality of functional modules, for example, a surface manager (surface manager), a three-dimensional (3D) graphics processing library (for example, OpenGL ES), a two-dimensional (2D) graphics engine (for example, SGL), and a media library (media library).

The surface manager is configured to manage a display subsystem, and provides fusion of 2D and 3D layers for a plurality of applications.

The three-dimensional graphics processing library is configured to implement three-dimensional graphics drawing, image rendering, composition, layer processing, and the like.

The 2D graphics engine is a drawing engine for 2D drawing.

In some embodiments, the three-dimensional graphics processing library may be configured to draw a three-dimensional motion trajectory image, and the 2D graphics engine may be configured to draw a two-dimensional motion trajectory image.

The media library supports playback and recording in a plurality of commonly used audio and video formats, static image files, and the like. The media library may support a plurality of audio and video encoding formats, for example, MPEG4, H.264, MP3, AAC, AMR, JPG, and PNG.

The kernel layer is a layer between hardware and software. The kernel layer includes at least a display driver, a camera driver, an audio driver, and a sensor driver.

The hardware layer may include various sensors, such as an acceleration sensor, a gravity sensor, and a touch sensor.

Generally, a plurality of applications may run simultaneously on the terminal device 200. In a relatively simple manner, one application may correspond to one process; and in a relatively complex manner, one application may correspond to a plurality of processes. Each process has a process ID (process ID).

It should be understood that the hardware structure of the terminal device may be shown in FIG. 1, and the software architecture of the terminal device may be shown in FIG. 2. A software program and/or a module corresponding to the software architecture in the terminal device may be stored in the memory 240. The processor 230 may run the software program and the application that are stored in the memory 240, to perform a procedure of a method for determining a battery level status provided in embodiments of this application.

It should be understood that in embodiments of this application, "at least one" means one or more, and "a plurality of" means two or more. The term "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between associated objects. "At least one of the following items (pieces)" or a similar expression thereof indicates any combination of these items, including a single item (piece) or any combination of a plurality of items (pieces). For example, at least one item (piece) of a, b, or c may represent: a, b, c, a and b, a and c, b and c, or a, b and c, where a, b, and c may be a singular or plural.

"A plurality of" in embodiments of this application indicates two or more.

In addition, it should be understood that in descriptions of this application, terms such as "first" and "second" are merely used for distinguishing and description, but should not be understood as indicating or implying relative importance, or should not be understood as indicating or implying a sequence.

In addition, in embodiments of this application, a "terminal device", a "device", and the like may be interchangeably used. To be specific, the "terminal device" and the "device" refer to various devices that can be used to implement embodiments of this application.

With reference to the description of the hardware structure of the terminal device in FIG. 1 and the description of the software architecture of the terminal device in FIG. 2, the following describes, by using examples with reference to a plurality of embodiments and the accompanying drawings, working principles of software and hardware that are used by the terminal device to perform the method for determining a battery level status provided in embodiments of this application.

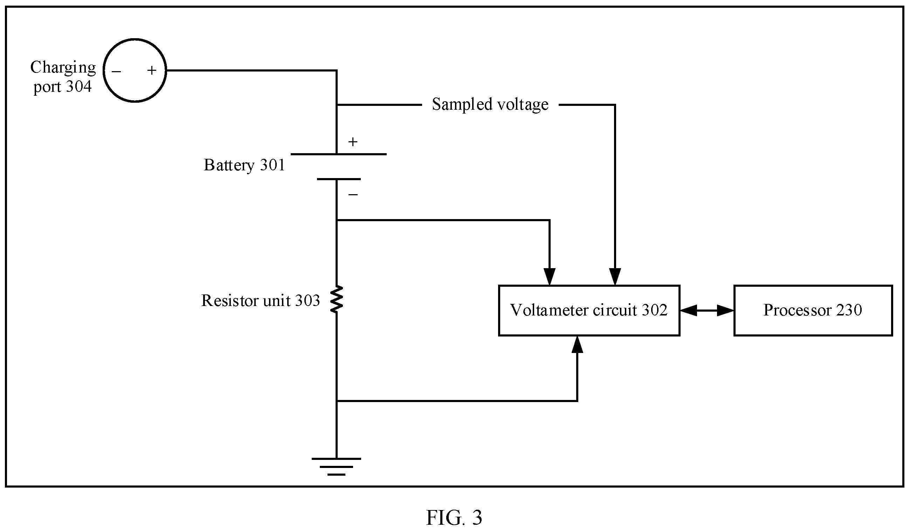

FIG. 3 is a diagram of a hardware structure to which a method for determining a battery level status is applicable according to an embodiment of this application. The hardware structure may include a battery 301 (for example, may be the power supply 220 shown in FIG. 1), a voltameter (or may also be referred to as a "coulomb counter" and the like, and the voltameter is used for description in the following embodiments) circuit 302, a resistor unit 303, a processor 230, and a charging port 304 (for example, may be the communication interface 280 shown in FIG. 1).

The battery 301 may be configured to provide energy for the terminal device 200, to ensure normal use of the terminal device 200.

The voltameter circuit 302 may be configured to sample voltages at both ends of the battery 301, and may be further configured to sample a current (or a current input to the resistor unit 303) output by the battery 301. Alternatively, based on a requirement in an actual scenario, the voltameter circuit 302 may be further configured to sample another type of battery-related data, for example, battery usage data.

The resistor unit 303 may be configured for the voltameter circuit 302 to sample a current or the like.

The processor 230 may be configured to receive sampled data (for example, data such as a battery voltage and a battery current) from the voltameter circuit 302, and may implement mapping between a voltage and a battery level status based on the sampled data, to determine processing like obtaining the battery level status.

The charging port 304 may be configured to charge the battery 301, to ensure battery level storage of the battery 301.

Based on the diagram of the hardware structure shown in FIG. 3, the processor 230 included in the terminal device 200 may obtain, from the voltameter circuit 302, sampled data of the battery 301, and perform statistics collection on the sampled data, to obtain battery usage data. Further, a mapped battery level status may be determined based on the battery usage data.

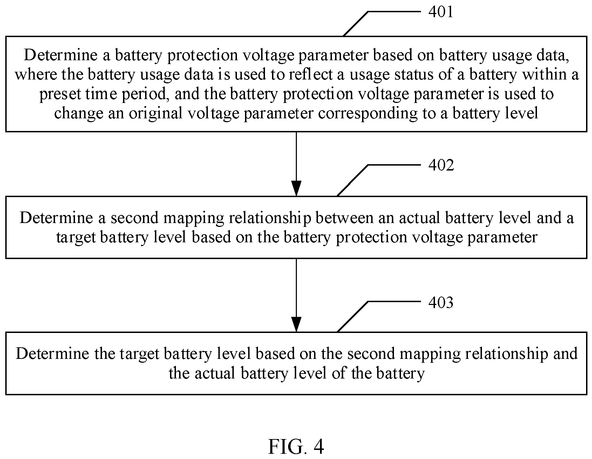

FIG. 4 is a schematic flowchart of a method for determining a battery level status according to an embodiment of this application. The method may be applied to a terminal device, and includes at least the following procedure.

Step 401: Determine a battery protection voltage parameter based on battery usage data, where the battery usage data is used to reflect a usage status of a battery within a preset time period, and the battery protection voltage parameter is used to change an original voltage parameter corresponding to a battery level.

The battery usage data may include but is not limited to one or a combination of the following information: a full charge capacity (full charge capacity, FCC), a first battery level when charging starts (or may be briefly referred to as a "start-of-charging battery level" in this embodiment of this application), a second battery level when charging stops (or may be briefly referred to as a "stop-of-charging battery level" in this embodiment of this application), battery usage duration, and a quantity of battery (charging/discharging) cycles. It may be understood that information included in the battery usage data may be a plurality of groups of data obtained through statistics collection within the preset time period. For example, the FCC, the start-of-charging battery level, and the stop-of-charging battery level may be data obtained by performing charging for a plurality of times within the preset time period.

Optionally, the terminal device may perform collection and statistics collection on an included battery, to obtain the battery usage data. In addition, the preset time period may be a corresponding time period from a moment at which the collection starts to a moment at which the method provided in this application is implemented. In addition, in the terminal device, the battery usage data may be continuously collected, and statistics collection may be continuously performed on the battery usage data. In this way, the method provided in this application may be continuously implemented based on historical battery usage data obtained through statistics collection. In addition, the terminal device may trigger collection and statistics collection on the battery usage data based on different preset collection instructions. The preset collection instruction may be configured based on an actual scenario, and the like.

In an optional embodiment, when detecting and responding to power-on of the terminal device, hardware units included in the terminal device start to work. During implementation of this application, after starting to work, the processor 230 may start to collect the battery usage data. For example, when it is detected that the battery 301 is fully charged, FCC data is collected; when it is detected that the battery 301 starts to be charged, the start-of-charging battery level is collected; and when it is detected that the battery 301 stops being charged, the stop-of-charging battery level is collected. In addition, during each charging, changes of a battery level in a charging/discharging process are accumulated. If it is collected that the battery completes a complete charging/discharging periodicity, a quantity of battery cycles is updated. In addition, the collected battery usage duration may be usage duration of the battery after the battery is powered on, usage duration of the battery after the battery is fully charged, or the like. A manner of performing statistics collection on the battery usage duration is not limited in this application. It may be understood that the processor 230 may collect and perform statistics collection on different pieces of information of the battery usage data by using different processes, or may collect and perform statistics collection on some information by using a same process.

In another optional embodiment, alternatively, when detecting or responding to charging of the terminal device, the processor 230 starts to collect and perform statistics collection on the battery usage data.

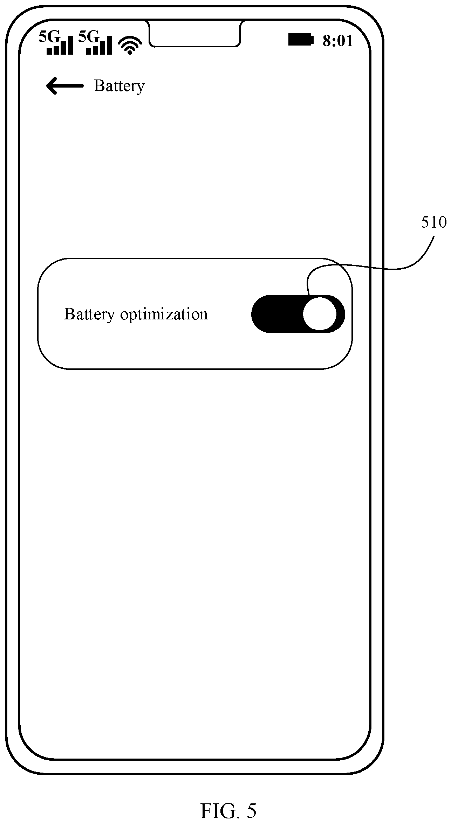

In still another optional embodiment, the terminal device may alternatively receive and respond to a user operation instruction for enabling battery optimization by the user, and start to collect and perform statistics collection on the battery usage data. For example, a display interface that corresponds to the battery and that is on the display panel 261 of the terminal device may include a battery optimization control used to update a battery level status. For example, a display interface of the terminal device shown in FIG. 5 includes a battery optimization control 510. As shown in FIG. 5, if the user enables the battery optimization control 510, the terminal device may start to perform the method for determining a battery level status provided in embodiments of this application, to perform battery optimization by updating the battery level status. If the user does not enable the battery optimization control 510 (not shown in FIG. 5), the terminal device may determine a battery level of the terminal device based on a collected battery level.

In addition, in the foregoing embodiments, after the terminal device is restarted, the processor 230 may further restart to collect and perform statistics collection on battery usage data. In this way, data storage pressure can be reduced, and a more accurate mapped target battery level can be obtained based on latest battery usage data. It may be understood that, if the battery of the terminal device is replaced, the processor 230 may also restart sampling and perform statistics collection on battery usage data, and discard the battery usage data collected and stored for the original battery.

In another optional embodiment, the terminal device may alternatively receive battery usage data sent by another device (for example, a server). The battery usage data may be, for example, obtained by the another device in another manner. It may be understood that a manner of obtaining the battery usage data is not limited in this embodiment of this application.

In an optional implementation, the terminal device may determine, based on a preconfigured first mapping relationship, the battery protection voltage parameter corresponding to the battery usage data. The preconfigured first mapping relationship may be stored in the memory 240.

Optionally, the preconfigured first mapping relationship may be used to reflect correspondences between different battery usage data values and different battery protection voltage parameter values, or may be used to reflect correspondences between different battery usage data ranges and different battery protection voltage parameter values/ranges. In this way, after collecting the battery usage data, the terminal device may determine the corresponding battery protection voltage parameter based on the first mapping relationship.

For example, the preconfigured first mapping relationship may be obtained by performing configuration based on a plurality of groups of experimental data. In this way, a preferable first mapping relationship can be obtained. For another example, the terminal device may alternatively obtain the preconfigured first mapping relationship based on deep learning. For example, a plurality of groups of correspondences between battery usage data and battery protection voltage parameters may be obtained in advance through an experiment or the like, and then the plurality of groups of correspondences may be used as training samples for deep learning, to obtain the first mapping relationship. It may be understood that the battery protection voltage parameter obtained based on the preconfigured first mapping relationship in a process of using the terminal device may also be used as a training sample for optimizing a deep learning model, to improve accuracy of the first mapping relationship. It should be noted that a manner of obtaining the preconfigured first mapping relationship is not limited during implementation of this application. For example, the first mapping relationship may alternatively be automatically generated based on an actual service scenario.

In another optional implementation, the terminal device may alternatively determine the battery protection voltage parameter based on the battery usage data in combination with another parameter. For example, the another parameter may be application running information or the like of the terminal device.

During implementation of this application, the battery protection voltage parameter is used to change the original voltage parameter corresponding to the battery level. This may be implemented as changing an original power-off voltage, an original full charge voltage, or another voltage corresponding to the battery level. Optionally, if the battery protection voltage parameter is used to change a target power-off voltage of the battery, the battery protection voltage parameter may include a target power-off voltage parameter for changing the original power-off voltage. In another optional implementation, if the battery protection voltage parameter is used to change a target full charge voltage of the battery, the battery protection voltage parameter may include a target full charge voltage parameter for changing the original full charge voltage. In still another optional implementation, if the battery protection voltage parameter is used to change the target power-off voltage and the target full charge voltage of the battery, the battery protection voltage parameter may include the target power-off voltage parameter and the target full charge voltage parameter.

Target protection voltage parameters such as the target power-off voltage parameter and the target full charge voltage parameter may have different representation forms. For example, the following representation forms may be included:

(1) Absolute value of a change value: For example, the target power-off voltage parameter may be represented as an increase of 50 millivolts (mV), or represented as +50 mV; and the target full charge voltage parameter may be represented as a decrease of 100 mV, or represented as -100 mV.

(2) Relative value of a change ratio: For example, the target power-off voltage parameter may be represented as an increase of 1%, and the target full charge voltage parameter may be represented as 2%.

(3) Target value obtained after a change: For example, the target power-off voltage parameter may be represented as 3.3 V. It may be understood that the target power-off voltage parameter may be different from the original power-off voltage parameter, and the original power-off voltage parameter may be, for example, 3.2 V. The target full charge voltage parameter may be represented as 4.4 V. It may be understood that the target full charge voltage parameter may be different from the original full charge voltage parameter, and the original full charge voltage parameter may be, for example, 4.5 V.

In addition, one or more voltage parameters included in the battery protection voltage parameter may be values, or may be value ranges. For example, the target power-off voltage parameter included in the battery protection voltage parameter may be 3.3 V, or may range from 3.25 V to 3.35 V. For example, when the terminal device periodically collects a battery voltage or collects a battery voltage in response to a collection instruction, if it is determined that the battery voltage falls within a value range corresponding to the target power-off voltage parameter, power-off of the terminal device may be triggered.

Step 402: Determine a second mapping relationship between an actual battery level and a target battery level based on the battery protection voltage parameter.

In an optional implementation, the second mapping relationship corresponding to the battery protection voltage parameter is determined based on a first modeling parameter, where the first modeling parameter indicates a correspondence between a battery voltage and a battery level. For example, the first modeling parameter may be represented as SOC=f(V), where SOC may represent the battery level, and f(V) may represent a battery voltage function corresponding to the battery level.

Optionally, for example, the battery protection voltage parameter is represented in the foregoing form of an absolute value. The second mapping relationship between the actual battery level and the target battery level may be determined below by using Formula 1-1 to Formula 7:

$$100\% = SOC_{\text{original full charge battery level}} = f(V_{\text{original full charge voltage}}) \quad \text{Formula 1-1}$$

$$0\% = SOC_{\text{original power-off battery level}} = f(V_{\text{original power-off voltage}}) \quad \text{Formula 1-2}$$

$$SOC_{\text{target full charge battery level}} = f(V_{\text{original full charge voltage}} - \triangle V_{\text{decreased voltage}})$$

Formula 1-3

$$SOC_{\text{target power-off battery level}} = f(V_{\text{original power-off voltage}} - \triangle V_{\text{increased voltage}})$$

Formula 1-4

It is assumed that the second mapping relationship between the actual battery level and the target battery level is represented by using Formula 1-5:

$$SOC_{\text{target battery level}} = \pm kSOC_{\text{actual battery level}} \pm b \quad \text{Formula 1-5}$$

Because k and b in Formula 1-5 are constants, and symbols of k and b are not limited in this application, the second mapping relationship may be set in a plurality of forms. For example, Formula 1-5 may include four forms. In this embodiment of this application, $SOC_{\text{target battery level}} = kSOC_{\text{actual battery level}} - b$ is used as an example for description. It may be understood that, regardless of a specific form of Formula 1-5, results that are of the second mapping relationship and that are obtained through calculation are consistent.

If Formula 1-3 and Formula 1-4 are separately combined with Formula 1-5, Formula 1-6 and Formula 1-7 may be obtained:

$$SOC_{\text{target full charge battery level}} = kSOC_{\text{original full charge battery level}} - b \quad \text{Formula 1-6}$$

$$SOC_{\text{target power-off battery level}} = kSOC_{\text{original power-off battery level}} - b \quad \text{Formula 1-7}$$

Herein, $SOC_{\text{target full charge}}$ battery level may be obtained by using Formula 1-3, $SOC_{\text{target power-off battery level}}$ may be obtained by using Formula 1-4, $SOC_{\text{original full charge battery level}}$ is 100%, and $SOC_{\text{original power-off battery level}}$ is 0%. Therefore, a value of k and a value of b may be obtained through calculation based on Formula 1-6 and Formula 1-7, so that the second mapping relationship in Formula 1-5 can be obtained.

In another optional implementation, if the battery protection voltage parameter is represented in the foregoing form of a relative value in the foregoing content, based on Formula 1-1 and Formula 1-2, Formula 1-3 and Formula 1-4 may be represented as Formula 2-3 and Formula 2-4:

$$SOC_{\text{target full charge battey level}} = f(V_{\text{original full charge voltage}} * (1 - T_1)) \quad \text{Formula 2-3}$$

$$SOC_{\text{target power-off battery level}} = f(V_{\text{original power-off voltage}} * (1 + T_2)) \quad \text{Formula 2-4}$$

Herein, $T_1$ represents a relative value of an adjustment to the original full charge voltage, for example, may be represented by a percentage, for example, 5%. In this case, Formula 2-3 represents that the target full charge voltage is reduced by 5% compared with the original full charge voltage. Similarly, $T_2$ represents a relative value of an adjustment to the original power-off voltage. It is assumed that the relative value is 7%. In this case, Formula 2-4 represents that the target power-off voltage is increased by 7% compared with the original power-off voltage.

In addition, for an implementation of determining the second mapping relationship between the actual battery level and the target battery level in this embodiment, refer to the foregoing embodiment. Details are not described herein again.

In still another optional implementation, if the battery protection voltage parameter is represented in the foregoing form of a target value in the foregoing content, based on Formula 1-1 and Formula 1-2, Formula 1-3 and Formula 1-4 may be further represented as Formula 3-3 and Formula 3-4:

$$SOC_{\text{target full charge battery level}} = f(V_{\text{target full charge voltage}}) \quad \text{Formula 3-3}$$

$$SOC_{\text{target power-off battery level}} = f(V_{\text{target power-off voltage}}) \quad \text{Formula 3-4}$$

It may be understood that, for an implementation of determining the second mapping relationship between the actual battery level and the target battery level in this embodiment, also refer to the foregoing embodiment. Details are not described herein again.

In addition, the first modeling parameter may further reflect the correspondence between the battery voltage and the battery level in combination with other data information of the battery. For example, the other data information may include but is not limited to current information and temperature information.

The first modeling parameter may alternatively be prestored in the memory 240. For example, the first modeling parameter may be obtained based on a plurality of groups of experimental data values, and then preconfigured in the terminal device.

In another optional implementation, the terminal device may alternatively determine the second mapping relationship between the actual battery level and the target battery level based on the battery protection voltage parameter in combination with another parameter. For example, the another parameter may be information about a battery temperature, a battery current, or the like.

Step 403: Determine the target battery level based on the second mapping relationship and the actual battery level of the battery.

Optionally, the processor 230 may collect a current actual battery level in real time, and obtain a mapped target battery level based on the actual battery level and the second mapping relationship shown in Formula 1-5. For example, the processor 230 may collect the actual battery level of 30%, and obtain the target battery level of 16% after mapping. Optionally, if the terminal device enables that a power saving mode is automatically enabled when the battery level is lower than 20%. For another example, the processor 230 may collect the actual battery level of 10%, and obtain the target battery level of 0% after mapping. In this case, a power management system of the terminal device detects that the target battery level is displayed as 0, and an automatic power-off procedure may be triggered.

It should be noted that, during implementation of this application, obtaining the actual battery level of the battery may be implemented as continuously collecting a battery parameter used to determine the actual battery level, and then determining the actual battery level of the battery based on the battery parameter. The battery parameter may be, for example, a battery current parameter, a battery voltage parameter, or the like. Alternatively, the obtaining the actual battery level of the battery may be further implemented as periodically collecting the battery parameter, and determining an actual battery level of the battery in a current periodicity based on the battery parameter. Alternatively, the obtaining the actual battery level of the battery may be further implemented as receiving a request instruction, collecting the battery parameter in response to the request instruction, and determining the actual battery level of the battery based on the battery parameter. For example, if there is an application or a process requesting to invoke the battery level, the processor 230 may obtain the actual battery level of the battery in response to the application or the process.

In addition, optionally, after determining the mapped target battery level, the processor 230 may transmit the mapped target battery level to the display unit 260 for display, so that the user obtains the mapped target battery level. In another optional implementation, if the processor 230 receives an invoking request instruction from another application or process for obtaining the battery level, the processor 230 may feed back the mapped target battery level to the another application or process, to implement invoking processing of the another application or process on the terminal device.

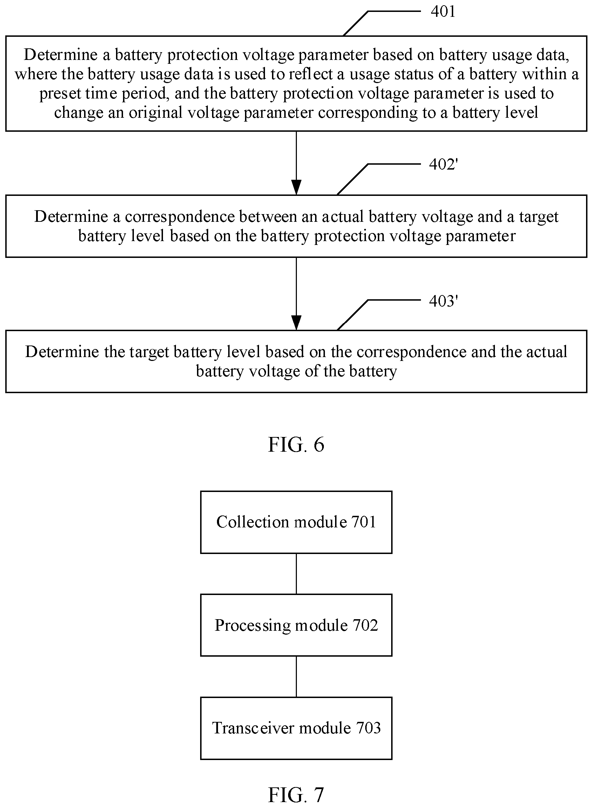

FIG. 6 is another schematic flowchart of a method for determining a battery level status according to an embodiment of this application. The method may be applied to a terminal device, and includes at least the following procedure.

Step 401: Determine a battery protection voltage parameter based on battery usage data, where the battery usage data is used to reflect a usage status of a battery within a preset time period, and the battery protection voltage parameter is used to change an original voltage parameter corresponding to a battery level.

For an implementation process of step 401, refer to content described in the foregoing implementations. Details are not described herein again.

Step 402': Determine a correspondence between an actual battery voltage and a target battery level based on the battery protection voltage parameter.

Optionally, a first modeling parameter is switched to a second modeling parameter based on a preconfigured third mapping relationship, where the first modeling parameter indicates an original correspondence between a battery voltage and a battery level, and the second modeling parameter indicates a target correspondence between the battery voltage and the battery level.

It is assumed that the first modeling parameter may be represented as SOC=f1(V), where SOC may represent the battery level, and f1(V) represents a first battery voltage function corresponding to the battery level.

For example, if the terminal device determines the battery protection voltage parameter based on collected battery usage data, it may be understood that a correspondence that is between an original battery voltage and an original battery level and that is indicated by the first modeling parameter is no longer applicable. During implementation of this application, a second modeling parameter used by the terminal device may be determined based on the battery protection voltage parameter. For example, the second modeling parameter may be represented as SOC=f2(V), where SOC may represent the battery level, and f2(V) represents a second battery voltage function corresponding to the battery level.

Optionally, the battery protection voltage parameter includes but is not limited to one or a combination of a target power-off voltage parameter and a target full charge voltage parameter. For example, the battery protection voltage parameter includes the target power-off voltage parameter. The processor 230 may find a proper second modeling parameter from the prestored third mapping relationship based on the target power-off voltage parameter. The preconfigured third mapping relationship may be used to reflect correspondences between different values of the battery protection voltage parameter and different modeling parameters, or may be further used to reflect correspondences between different ranges of the battery protection voltage parameter and different modeling parameters. It should be noted that a plurality of different modeling parameters may be preconfigured in the terminal device. For example, a total of five modeling parameters, namely, the first modeling parameter to a fifth modeling parameter, are prestored. One or more parameters included in the battery protection voltage parameter may be a parameter value, or may be a parameter range.

The preconfigured third mapping relationship may be stored in the memory 240.

Step 403': Determine the target battery level based on the correspondence and the actual battery voltage of the battery.

For example, the voltameter circuit 302 shown in FIG. 3 may be used to collect one or a combination of battery data such as voltage data, current data, and current integral data of the battery, and the target battery level of the battery may be obtained through calculation based on the second modeling parameter. It may be understood that, based on different correspondences that are between the battery voltage and the battery level and that are respectively indicated by the first modeling parameter and the second modeling parameter, different battery levels may be obtained when the voltameter circuit 302 collects same battery data of the battery.

According to the method provided in this application, based on the collected battery usage data, a corresponding battery protection voltage parameter may be set based on a battery usage status, to protect the battery. Further, a mapping relationship between the battery voltage and the battery level is changed, to determine a mapped battery level status. In the method, a mapping manner between the target battery level and the actual battery level may be calculated, to implement mapping from the battery voltage to the battery level; and the mapping relationship between the battery voltage and the battery level may be further changed, so that the battery level can be obtained through mapping based on the battery voltage.

Therefore, the target battery level obtained through mapping can not only reflect the actual battery level of the battery, but also can reflect a voltage status of the battery, so that when a battery voltage is low, a low target battery level can be obtained through mapping. In this way, a user can be reminded in a timely manner to charge a battery, and the battery can be prevented from being in a low-voltage state for a longer time. Therefore, a case in which the battery works in a dangerous voltage range for a long time can be better avoided based on dynamic mapping based on the battery voltage and the battery level. For example, a silicon negative electrode battery has unstable performance in a low voltage range, and therefore, a battery power-off voltage may be increased when the silicon negative electrode battery is used. Alternatively, for example, if a battery made of another material has poor performance in another voltage range (for example, a high voltage range) in the future, the battery may be protected by reducing a full charge voltage of the battery, to prolong a lifespan of the battery.

Based on the foregoing embodiments, this application further provides a terminal device. The terminal device includes a plurality of function modules, and the plurality of function modules interact with each other, to implement functions performed by the terminal device in the methods described in embodiments of this application. The plurality of function modules may be implemented based on software, hardware, or a combination of software and hardware, and the plurality of function modules may be randomly combined or divided based on specific implementation. For example, FIG. 7 is a diagram of a structure of an apparatus for determining a battery level status according to an embodiment of this application. The apparatus may include a collection module 701, a processing module 702, and a transceiver module 703. For example, the collection module 701 may be configured to collect battery usage data and the like. The processing module 702 may be configured to process the battery protection voltage parameter, the second mapping relationship, the target battery level, or the like described in the foregoing embodiments. The transceiver module 703 may be configured to receive data such as a real-time battery level collected by another hardware unit. For specific functions that can be implemented by each module, refer to content of the embodiments described in FIG. 4 to FIG. 6.

Based on the foregoing embodiments, this application further provides a terminal device. The terminal device includes at least one processor and at least one memory. The at least one memory stores computer program instructions. When the terminal device runs, the at least one processor performs functions performed by the terminal device in the methods described in embodiments of this application. For example, the at least one processor performs steps 401 to 403 performed by the terminal device in the embodiment shown in FIG. 4, or performs steps 401 to 403' performed by the terminal device in the embodiment shown in FIG. 6.

Based on the foregoing embodiments, this application further provides a computer program product. The computer program product includes a computer program (which may also be referred to as code or instructions). When the computer program is run, a computer is enabled to perform the methods described in embodiments of this application.

Based on the foregoing embodiments, this application further provides a computer-readable storage medium. The computer-readable storage medium stores a computer program. When the computer program is executed by a computer, the computer is enabled to perform the methods described in embodiments of this application.

Based on the foregoing embodiments, this application further provides a chip. The chip is configured to read a computer program stored in a memory, to implement the methods described in embodiments of this application.

Based on the foregoing embodiments, this application provides a chip system. The chip system includes a processor, configured to support a computer apparatus in implementing the methods described in embodiments of this application. In a possible design, the chip system further includes a memory, and the memory is configured to store a program and data that are necessary for the computer apparatus. The chip system may include a chip, or may include a chip and another discrete component. A person skilled in the art should understand that embodiments of this application may be provided as a method, a system, or a computer program product. Therefore, this application may use a form of hardware only embodiments, software only embodiments, or embodiments with a combination of software and hardware. Moreover, this application may use a form of a computer program product that is implemented on one or more computer-usable storage media (including but not limited to a disk memory, a CD-ROM, an optical memory, and the like) that include computer usable program code.

This application is described with reference to the flowcharts and/or block diagrams of the method, the device (system), and the computer program product according to this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may alternatively be stored in a computer-readable memory capable of directing a computer or another programmable data processing device to work in a particular manner, so that instructions stored in the computer-readable memory generate a manufacture including an instruction apparatus, and the instruction apparatus implements a function specified in one or more processes in the flowcharts and/or one or more blocks in the block diagrams.

These computer program instructions may alternatively be loaded onto a computer or another programmable data processing device, so that a series of operation steps are performed on the computer or the another programmable device to produce computer-implemented processing. Therefore, the instructions executed on the computer or the another programmable device provide steps for implementing functions specified in one or more processes in the flowcharts and/or one or more blocks in the block diagrams.

It is clear that a person skilled in the art can make various modifications and variations to this application without departing from the protection scope of this application. In this way, this application is intended to cover these modifications and variations of this application provided that they fall within the scope of protection defined by the following claims and their equivalent technologies.

**Claims**

1. A method for determining a battery level status, comprising:

determining a battery protection voltage parameter based on battery usage data, wherein the battery usage data is used to reflect a usage status of a battery within a preset time period, and the battery protection voltage parameter is used to change an original voltage parameter corresponding to a battery level;

determining a second mapping relationship between an actual battery level and a target battery level based on the battery protection voltage parameter; and

determining the target battery level based on the second mapping relationship and the actual battery level of the battery.

2. A method for determining a battery level status, comprising:

determining a battery protection voltage parameter based on battery usage data, wherein the battery usage data is used to reflect a usage status of a battery within a preset time period, and the battery protection voltage parameter is used to change one or more original battery voltages corresponding to a battery level;

determining a correspondence between an actual battery voltage and a target battery level based on the battery protection voltage parameter; and

determining the target battery level based on the correspondence and the actual battery voltage of the battery.

3. The method according to claim 1 or 2, wherein the determining a battery protection voltage parameter based on battery usage data comprises:

determining, based on a preconfigured first mapping relationship, the battery protection voltage parameter corresponding to the battery usage data.

4. The method according to claim 3, wherein the preconfigured first mapping relationship is used to reflect correspondences between different battery usage data values and different battery protection voltage parameter values; or

the preconfigured first mapping relationship is used to reflect correspondences between different battery usage data ranges and different battery protection voltage parameter values or ranges.

5. The method according to claim 1, wherein the determining a second mapping relationship between an actual battery level and a target battery level based on the battery protection voltage parameter comprises:

determining, based on a first modeling parameter, the second mapping relationship corresponding to the battery protection voltage parameter, wherein the first modeling parameter indicates a correspondence between a battery voltage and a battery level.

6. The method according to claim 2, wherein the determining a correspondence between an actual battery voltage and a target battery level based on the battery protection voltage parameter comprises:

switching a first modeling parameter to a second modeling parameter based on a preconfigured third mapping relationship, wherein the first modeling parameter indicates an original correspondence between a battery voltage and a battery level, and the second modeling parameter indicates a target correspondence between the battery voltage and the battery level.

7. The method according to any one of claims 1 to 6, wherein the battery usage data comprises one or more of the following information:

a full charge capacity FCC, a first battery level when charging starts, a second battery level when charging stops, battery usage duration, and a quantity of battery cycles.

8. The method according to any one of claims 1 to 7, wherein before the determining a battery protection voltage parameter based on battery usage data, the method further comprises:

receiving and responding to a preset collection instruction, and collecting and performing statistics collection on the battery usage data, wherein

the preset collection instruction comprises: detecting power-on of a terminal device; or detecting charging of the terminal device; or receiving a user operation instruction for enabling battery optimization by a user.

9. The method according to any one of claims 1 to 8, wherein the battery protection voltage parameter comprises at least one of the following parameters:

a target power-off voltage obtained by changing an original power-off voltage that is comprised in the original voltage parameter; and

a target full charge voltage obtained by changing an original full charge voltage that is comprised in the original voltage parameter.

10. The method according to any one of claims 1 to 9, wherein the battery protection voltage parameter is represented in one of the following forms:

an absolute value of a change value;
a relative value of a change ratio; and
a target value obtained after a change.

11. The method according to claim 1, wherein obtaining the actual battery level of the battery comprises:

continuously collecting a battery parameter used to determine the actual battery level, or periodically collecting the battery parameter, or receiving a request instruction, and collecting the battery parameter in response to the request instruction; and
determining the actual battery level based on the battery parameter.

12. A terminal device, comprising at least one processor, wherein the at least one processor is coupled to at least one memory, and the at least one processor is configured to read a computer program stored in the at least one memory, to perform the method according to any one of claims 1 to 11.

13. A computer-readable storage medium, wherein the computer-readable storage medium stores instructions, and when the instructions are run on a computer, the computer is enabled to perform the method according to any one of claims 1 to 11.

14. A computer program product comprising instructions, wherein when the computer program product runs on a computer, the computer is enabled to perform the method according to any one of claims 1 to 11.

15. A graphical user interface on a terminal device, wherein the terminal device has a display, one or more memories, and one or more processors, the one or more processors are configured to execute one or more computer programs stored in the one or more memories, and the graphical user interface comprises a graphical user interface displayed when the terminal device performs the method according to any one of claims 1 to 11.

FIG. 1

| Application layer | Camera | Settings | Skin module | User interface |
|---|---|---|---|---|
| | WLAN | Music | Call | Bluetooth |
| | Videos | ... | | |

| Application framework layer | Shortcut icon management module | Window manager | Content provider |
|---|---|---|---|
| | Phone manager | View system | Notification manager |
| | Resource manager | ... | |

| System library | Surface manager | Three-dimensional graphics processing library | Runtime |
|---|---|---|---|
| | Two-dimensional graphics engine | Media library | ... |

| Kernel layer | Display driver | Camera driver | |
|---|---|---|---|
| | Audio driver | Sensor driver | ... |

| Hardware layer | Acceleration sensor | Gravity sensor | Touch sensor |
|---|---|---|---|

FIG. 2

FIG. 3

401

Determine a battery protection voltage parameter based on battery usage data, where the battery usage data is used to reflect a usage status of a battery within a preset time period, and the battery protection voltage parameter is used to change an original voltage parameter corresponding to a battery level

402

Determine a second mapping relationship between an actual battery level and a target battery level based on the battery protection voltage parameter

403

Determine the target battery level based on the second mapping relationship and the actual battery level of the battery

FIG. 4

FIG. 5

401

Determine a battery protection voltage parameter based on battery usage data, where the battery usage data is used to reflect a usage status of a battery within a preset time period, and the battery protection voltage parameter is used to change an original voltage parameter corresponding to a battery level

402'

Determine a correspondence between an actual battery voltage and a target battery level based on the battery protection voltage parameter

403'

Determine the target battery level based on the correspondence and the actual battery voltage of the battery

FIG. 6

Collection module 701

Processing module 702

Transceiver module 703

FIG. 7

## INTERNATIONAL SEARCH REPORT

| International application No. |
| --- |
| **PCT/CN2023/088942** |

**A. CLASSIFICATION OF SUBJECT MATTER**

G01R31/388(2019.01)i; G01R31/389(2019.01)i; G01R31/396(2019.01)i; G01R31/367(2019.01)i

According to International Patent Classification (IPC) or to both national classification and IPC

**B. FIELDS SEARCHED**

Minimum documentation searched (classification system followed by classification symbols)

IPC:G01R

Documentation searched other than minimum documentation to the extent that such documents are included in the fields searched

Electronic data base consulted during the international search (name of data base and, where practicable, search terms used)

CNTXT; WPABS; WPABSC; ENTXT; ENTXTC; CNKI; IEEE: 华为, 李园, 崔瑞, 阮嘉濠, 刘玉桃, 王晗, 保护电压, 充电截止电压, 电压上限, 上限电压, 电压下限, 下限电压, 关机电压, 满充电压, 电池电量, 电量保持率, 荷电状态, 更新, 修正, 健康状态, 老化, 劣化, 映射, soc, state of charge, update, limit voltage, shutdown voltage, cut-off voltage, soh, state of health

**C. DOCUMENTS CONSIDERED TO BE RELEVANT**

| Category* | Citation of document, with indication, where appropriate, of the relevant passages | Relevant to claim No. |
| --- | --- | --- |
| Y | CN 111602308 A (GOOGLE INC.) 28 August 2020 (2020-08-28) description, paragraphs [0022]-[0029] and [0043]-[0074], and figures 1-9 | 1-15 |
| Y | CN 109342959 A (SOUNDON NEW ENERGY TECHNOLOGY CO., LTD.) 15 February 2019 (2019-02-15) description, paragraphs [0046]-[0056], and figure 2 | 1, 3-5, 7-15 |
| Y | CN 112622693 A (GUANGZHOU CHENGXING INTELLEGENT ELECTRIC AUTOMOTIVE TECHNOLOGY CO., LTD. et al.) 09 April 2021 (2021-04-09) description, paragraphs [0077]-[0082] | 2-4, 6-10, 12-15 |
| A | CN 105277909 A (HUNAN CSR TIMES ELECTRIC VEHICLE CO., LTD.) 27 January 2016 (2016-01-27) entire document | 1-15 |
| A | US 2012112754 A1 (DENSO CORP.) 10 May 2012 (2012-05-10) entire document | 1-15 |

☐ Further documents are listed in the continuation of Box C.    ☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **12 July 2023** | **23 July 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

International application No.

**PCT/CN2023/088942**

| Patent document cited in search report | | | Publication date (day/month/year) | Patent family member(s) | Publication date (day/month/year) |
|---|---|---|---|---|---|
| CN | 111602308 | A | 28 August 2020 | None | |
| CN | 109342959 | A | 15 February 2019 | None | |
| CN | 112622693 | A | 09 April 2021 | None | |
| CN | 105277909 | A | 27 January 2016 | None | |
| US | 2012112754 | A1 | 10 May 2012 | None | |

Form PCT/ISA/210 (patent family annex) (July 2022)

**REFERENCES CITED IN THE DESCRIPTION**

**Patent documents cited in the description**

- CN 202210457988